# EUROPÄISCHE PATENTSCHRIFT

(11) **EP 0 262 530 B1**
(45) Veröffentlichungstag und Bekanntmachung des Hinweises auf die Patenterteilung: **23.06.1993**
(21) Anmeldenummer: 87113707.1
(22) Anmeldetag: 18.09.1987
(51) Int. Cl.: H01L 25/04, H01L 25/16

(54) **Halbleiterbauelemente mit Leistungs-MOSFET und Steuerschaltung**
Semiconductor components having a power MOSFET and control circuit
Composants semi-conducteurs comprenant un MOSFET de puissance et un circuit de commande

(30) Priorität: 23.09.1986 DE 3632199
(43) Veröffentlichungstag der Anmeldung: 06.04.1988
(73) Patentinhaber: SIEMENS AKTIENGESELLSCHAFT, 80333 München (DE)
(72) Erfinder: Einzinger, Josef, Dipl.-Ing., D-8044 Unterschleissheim (DE); Leipold, Ludwig, Dipl.-Ing., D-8000 München 40 (DE); Tihanyi, Jenö, Dr., D-8000 München 70 (DE); Weber, Roland, Dipl.-Ing., D-8000 München 40 (DE)

(56) Entgegenhaltungen:
- EP-A- 0 067 752
- EP-A- 0 078 194
- EP-A- 0 208 970
- US-A- 4 314 270
- PATENT ABSTRACTS OF JAPAN, Band 9, Nr. 204 (E-337)[1927], 21. August 1985; & JP-A-60 70 752
- Idem
- PATENT ABSTRACTS OF JAPAN, Band 9, Nr. 65 (E-304)[1788], 26. März 1985; & JP-A-59 202 658

## Beschreibung

Die Erfindung bezieht sich auf ein Halbleiterbauelement mit einem einen Transistor enthaltenden ersten Halbleiterkörper und mit einem zweiten Halbleiterkörper, der eine integrierte Steuerschaltung enthält, bei dem beide Halbleiterkörper mechanisch über eine ihrer Hauptflächen miteinander verbunden sind und in thermischen Kontakt miteinander stehen, sowie mit Gehäuseanschlüssen für die Steuerschaltung.

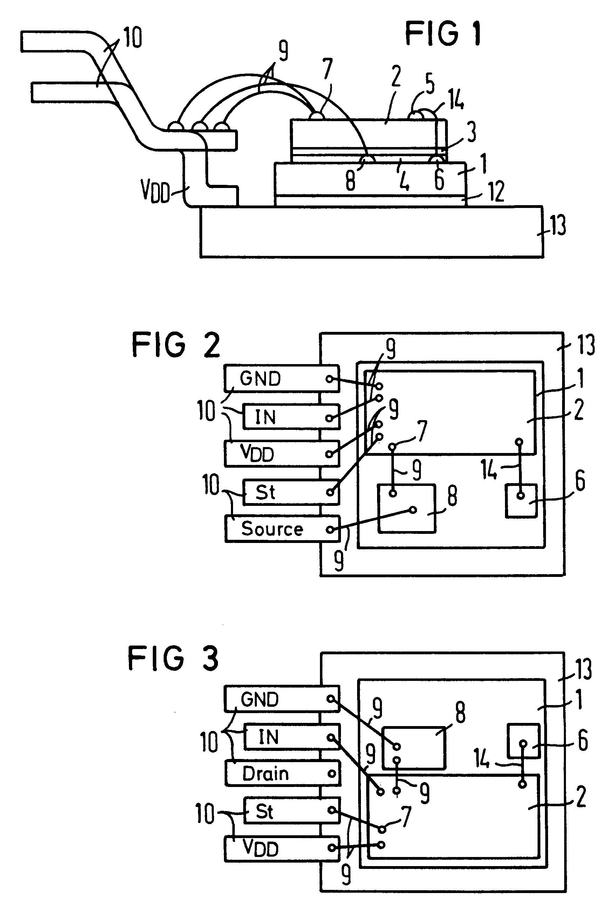

Ein solches Halbleiterbauelement ist z. B. im US-Patent 4,314,270, insbesondere in Verbindung mit Figur 1 beschrieben worden. Hier sitzt ein Bipolartransistor auf einer integrierten Dickschichtschaltung, die den Bipolartransistor steuert. Eine Beeinflussung der integrierten Schaltung durch den Bipolartransistor findet offensichtlich nicht statt. Dies ist auch nicht notwendig, da sich ein Bipolartransistor vor Überlast im gewissen Umfang dadurch schützt, daß mit steigender Temperatur sein Widerstand zunimmt.

Bei Leistungs-MOSFET ist dieser Schutzmechanismus nicht gegeben, da sein Widerstand mit steigender Temperatur abnimmt. Es ist daher wichtig, daß Maßnahmen getroffen werden, die einen Leistungs-MOSFET vor Überlastung schützen.

Ziel der Erfindung ist es, ein Halbleiterbauelement der genannten Art für einen Leistungs-MOSFET so auszubilden, daß sein Schutz gegen Überlast gewährleistet ist.

Dieses Ziel wird dadurch erreicht, daß der Transistor ein Leistungs-MOSFET ist, daß beide Halbleiterkörper über eine Isolierschicht miteinander verbunden sind, daß die Steuerschaltung einen Temperaturfühler enthält, der elektrisch mit einem Schalter derart verbunden ist, daß der Schalter bei Erreichen einer vorgegebenen, im Leistungs-MOSFET auftretenden Grenztemperatur ein Signal erzeugt und daß eine der Gehäuseanschlüsse als Steuereingang (IN) der Steuerschaltung vorgesehen ist, wobei ein Signal auf den Steuereingang (IN) den Leistungs-MOSFET über die Steuerschaltung einschaltet.

In der nach Artikel 54 (3) EPÜ zu berücksichtigenden europäischen Patentanmeldung 208 970 ist zwar ein Leistungs-MOSFET beschrieben, auf dessen Hauptfläche ein weiterer Halbleiterkörper angeordnet ist. Dieser enthält jedoch keine Steuerschaltung, sondern eine Schutzschaltung für den Leistungs-MOSFET. In der europäischen Anmeldung 78 194 ist auch ein Halbleiterbauelement beschrieben, bei dem zwei Halbleiterkörper übereinander angeordnet und miteinander verbunden sind. Die Halbleiterkörper können Speicher, Multiplexer oder ähnliches sein. Sie enthalten jedoch keinen Leistungs-MOSFET und keine Steuerschaltung für diesen.

Weiterbildungen der Erfindung sind Gegenstand der Unteransprüche.

Die Erfindung wird anhand von Ausführungsbeispielen in Verbindung mit den Figuren 1 bis 5 näher erläutert. Es zeigen:
- Figur 1: eine Seitenansicht eines ersten Ausführungsbeispiels,
- Figur 2: die Aufsicht auf die Anordnung nach Figur 1,
- Figur 3: eine Aufsicht auf ein zweites Ausführungsbeispiel,
- Figur 4: eine Anordnung zur Zuführung der Versorgungsspannung für die Steuerschaltung und
- Figur 5: ein Beispiel eines Teils einer integrierten Steuerschaltung.

In Figur 1 und 2 ist der Leistungs-MOSFET mit 1 bezeichnet. Auf einer der Hauptflächen des Leistungs-MOSFET 1 ist die integrierte Steuerschaltung 2 angeordnet. Diese hat eine kleinere Fläche als der MOSFET 1. Sie ist gegen den Leistungs-MOSFET durch eine Isolierschicht 3 elektrisch isoliert und mittels einer Klebstoffschicht 4 mit dem Halbleiterkörper 1 mechanisch verbunden. Die Isolierschicht 3 kann z. B. aus Siliciumnitrid Si₃N₄ bestehen, die Schicht 4 aus einem Isolierkleber. Die Isolierschicht 3 kann Bestandteil des Halbleiterkörpers 2 oder des Halbleiterkörpers 1 sein. Im letzten Fall liegt dann die Klebstoffschicht zwischen der Isolierschicht 3 und dem Halbleiterkörper 2. Es ist jedoch auch möglich, die Isolierschicht 3 als Isolierfolie auszubilden und mit beiden Halbleiterkörpern zu verkleben.

Die aus den Halbleiterkörpern 1 und 2 gebildete Einheit ist auf einem Kühlkörper 13 befestigt. Zur Befestigung dient eine zwischen dem Halbleiterkörper 1 und dem Kühlkörper 13 liegende Schicht 12. Die Schicht 12 ist z. B. ein Leitkleber. Die Steuerschaltung ist durch an der Oberseite des Halbleiterkörpers 2 angeordnete Kontakte 7 über Leitungen 9 mit Gehäuseanschlüssen 10 elektrisch verbunden. Die Steuerschaltung steuert den Leistungs-FET über eine Leitung 14, der den Ausgang 5 der Steuerschaltung mit dem Gate-Anschluß 6 des Leistungs-FET verbindet. Der Source-Anschluß des Leistungs-FET wird über einen Kontakt 8 und zwei der Leitungen 9 mit dem Gehäuseanschluß "Source" und mit der Steuerschaltung verbunden.

Die Lage der Kontakte auf den Halbleiterkörpern 1 und 2 ist nicht an bestimmte Orte gebunden, sie können auch anders auf der Fläche der Halbleiterkörper angeordnet sein. Das Halbleiterbauelement hat einen Gehäuseanschluß GND für Masse. Dieser Gehäuseanschluß ist mit dem Halbleiterkörper 2 verbunden, da die Steuerschaltung mit der Verso rgungsspannung verbunden sein muß. Ein zweiter Gehäuseanschluß IN ist als Steuereingang vorgesehen. Ein Signal auf dem Steuereingang IN schaltet den Leistungs-FET über die Steuerschaltung ein. Der dritte Gehäuseanschluß V _{DD} dient zur Zuführung der Versorgungsspannung für die Steuerschaltung und ist direkt mit dem Kühlkörper 13 verbunden. Der Gehäuseanschluß ST dient der Rückmeldung von Störfällen z. B. Überstrom, Übertemperatur, Überspannung, Lastausfall usw.. Dem Gehäuseanschluß "Source" wird die Sourcespannung für den Leistungs-FET zugeführt.

Die Anordnung stellt einen sogenannten "High-Side"-Schalter dar, bei dem die Last zwischen Sourceanschluß des Leistungs-MOSFET und Masse angeschlossen wird und der Drainanschluß an V_{DD} liegt.
In Figur 3 ist ein "Low-Side"-Schalter dargestellt, bei dem die Last zwischen V_{DD} und dem Drainanschluß des Leistungs-MOSFET angeschlossen wird und der Sourceanschluß mit Masse verbunden ist. Die Bezugszeichen entsprechend denen der Figur 2. Im Unterschied zur Anordnung nach Figur 2 hat die Anordnung keinen Anschluß "Source", sondern einen Anschluß "Drain", der lediglich mit dem Kühlkörper 13 verbunden ist.

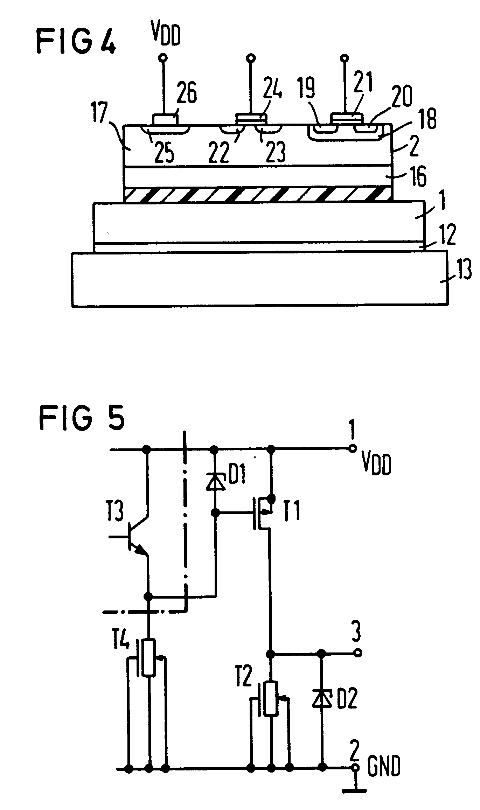

In Figur 4 ist ein Schnitt durch eine integrierte Steuerschaltung in stark vereinfachter Form dargestellt. Der Halbleiterkörper 1 des Leistungs-MOSFET und die übrigen Teile des Halbleiterbauelements sind nicht geschnitten dargestellt. Die Steuerschaltung ist in an sich bekannter Weise in selbstisolierender C-MOS-Technik hergestellt. Stellvertretend für die in allgemeinen ziemlich komplexen Strukturen sind hier lediglich schematisch zwei integrierte, zueinander komplementäre Lateral-MOSFET gezeigt. Der Halbleiterkörper 2 ist auf einem stark n-dotierten Substrat 16 aufgebaut. An das Substrat 16 grenzt eine schwach n-dotierte Epitaxieschicht 17 an. In die Schicht 17 ist eine p-dotierte Wanne eingebettet. In die Wanne 18 ist eine n-dotierte Source-Zone 19 und eine n-dotierte Drain-Zone 20 eingebettet. Dieser laterale n-Kanal-FET wird über eine Gate-Elektrode 21 gesteuert. Weiter ist in die Zone 17 eine p-dotierte Source-Zone 22 und eine p-dotierte Drain-Zone 23 eingebettet. Dieser laterale p-Kanal-FET wird durch eine Gate-Elektrode 24 gesteuert. Um die schematisch dargestellte und zur Erläuterung auf die notwendigsten Bestandteile reduzierte Steuerschaltung elektrisch mit dem Kühlkörper zu verbinden, ist in diejenige Hauptfläche, die von Leistungs-MOSFET abgewandt ist, eine stark n-dotierte Zone 25 eingebettet. Diese ist mit einem Kontakt 26 versehen und mit dem Gehäuseanschluß V_{DD} verbunden. Hierbei ist der Abstand zwischen der Zone 25 und einem integrierten Bauelement der Steuerschaltung um ein mehrfaches größer als die Dicke der Zone 17. Wird an den Anschluß V_{DD} Versorgungsspannung gelegt, so liegt auch die Zone 17 an Versorgungsspannung und der zwischen den Zonen 18 und 17 liegende pn-Übergang und die zwischen den Zonen 22, 23 und 17 liegenden pn-Übergänge werden in Sperrichtung vorgespannt. Damit werden die beiden MOSFET der Steuerschaltung elektrisch voneinander getrennt.

Die Steuerschaltung kann auch in der sogenannten Junction-Isolationstechnik ausgeführt werden, bei der funktionsverschiedene, in eine Epitaxieschicht eingebettete Teile durch bis zu einer entgegengesetzt dotierten Zone reichenden tiefen stark entgegengesetzt dotierten Zone von einander getrennt werden. Es ist auch möglich, die einzelnen Schaltungselemente der Steuerschaltung durch dielektrische Isolationen von einander zu trennen, indem jede Funktionseinheit in eine durch Isolierstoff isolierte Wanne in das Substrat eingebettet ist.

Die Steuerschaltung kann unteranderem vorzugsweise eine Schaltung enthalten, die temperaturempfindlich ist und bei Erreichen einer vorgegebenen Grenztemperatur ein Signal abgibt. In diesem Fall wird die Steuerschaltung derart mit dem Leistungsteil verbunden, daß zwischen den Halbleiterkörpern 1 und 2 ein guter thermischer Kontakt b esteht. Dies ist im allgemeinen bereits dann erfüllt, wenn beide Halbleiterkörper durch eine wenige µm starke Isolierschicht voneinander getrennt sind.

Eine solche Schaltungsanordnung zur Erzeugung eines Signals bei Übertemperaturen ist in Figur 5 dargestellt. Sie besteht aus der Reihenschaltung eines p-Kanal-FET T1 mit einem n-Kanal-MOSFET T2. T1 ist vom Anreicherungstyp und T2 vom Verarmungstyp. Der Transistor T1 ist mit seinem Source-Anschluß mit einer Klemme 1 verbunden, an der die Betriebsspannung V_{DD} liegt. Der Transistor T2 liegt sourceseitig über eine Klemme 2 an Masse GND. Der Gate-Anschluß von T2 ist mit seinem Source-Anschluß verbunden, er wirkt somit als Stromquelle. Den Transistoren T1, T2 ist die Reihenschaltung bestehend aus einem Bipolartransistor T3 und einem MOSFET T4 parallel geschaltet. Dabei ist der Drain-Anschluß von T4 mit dem Emitter-Anschluß von T3 verbunden, dessen Kollektoranschluß mit der Klemme 1 verbunden ist. Der Drain-Anschluß von T4 bzw. Emitteranschluß von T3 ist elektrisch mit dem Gate-Anschluß von T1 verbunden. Zwischen dem Gate-Anschluß von T1 und der Klemme 1 liegt eine erste, die Gate-Source-Vorspannung von T1 begrenzende Zenerdiode D1. Zwischen Source und Drain-Anschluß von T2 liegt eine die Ausgangsspannung begrenzende Zenerdiode D2.

Der Temperaturfühler wird durch den Bipolartransistor T3 gebildet. Alle anderen Bauelemente wirken als Schalter zur Erzeugung eines eine Übertemperatur anzeigenden Signals. Erwärmt sich nun der Leistungs-MOSFET 1 und damit T3, so steigt sein Strom an. Wird der durch T3 fließende Strom größer als derjenige Strom, der durch die Stromquelle T4 fließt, so nimmt der Innenwiderstand von T4 stark zu und die Spannung am Gate-Anschluß von T1 steigt von Massepotential ausgehend sprungartig an. Wird hierbei die Einsatzspannung von T1 unterschritten, so schaltet dieser aus und das Potential an der Klemme 3 fällt auf Massepotential zurück. Dieses Potential kann dann von einer an die Klemmen 3 und 2 angeschlossenen Logikschaltung als Übertemperatursignal detektiert werden und z. B. ein Abschalten des Leistungs-MOSFET bewirken.

Selbstverständlich kann die Steuerschaltung für die Erfüllung anderer Funktionen ausgelegt sein. Möglichkeiten hierfür sind z. B. in den älteren deutschen Patentanmeldungen P 36 09 235.5, P 36 09 236.3, P 36 24 565.8 beschrieben.

## Patentansprüche

1. Halbleiterbauelement mit einem einen Transistor enthaltenden ersten Halbleiterkörper (1) und mit einem zweiten Halbleiterkörper (2), der eine integrierte Steuerschaltung enthält, bei dem beide Halbleiterkörper mechanisch über eine ihrer Hauptflächen miteinander verbunden sind und in thermischen Kontakt miteinander stehen, sowie mit Gehäuseanschlüssen für die Steuerschaltung,
**dadurch gekennzeichnet,** daß der Transistor ein Leistungs-MOSFET ist, daß beide Halbleiterkörper über eine Isolierschicht (3, 4) miteinander verbunden sind, daß die Steuerschaltung einen Temperaturfühler (T3) enthält, der elektrisch mit einem Schalter (T1, T2, T4) derart verbunden ist, daß der Schalter bei Erreichen einer vorgegebenen, im Leistungs-MOSFET auftretenden Grenztemperatur ein Signal erzeugt und daß einer der Gehäuseanschlüsse als Steuereingang (IN) der Steuerschaltung vorgesehen ist, wobei ein Signal auf den Steuereingang (IN) den Leistungs-MOSFET über die Steuerschaltung einschaltet.

2. Halbleiterbauelement nach Anspruch 1,
**dadurch gekennzeichnet,** daß eine Hauptfläche des Halbleiterkörpers (1) des Leistungs-MOSFET auf einem Kühlkörper (13) befestigt ist und daß der Halbleiterkörper (2) der Steuerschaltung auf der anderen Hauptfläche sitzt.

3. Halbleiterbauelement nach Anspruch 1 oder 2,
**dadurch gekennzeichnet,** daß die Steuerschaltung auf einem hochdotierten Halbleitersubstrat (16) in selbstisolierender C-MOS-Technik aufgebaut ist und daß auf der vom Leistungs-MOSFET abgewandten Seite ihres Halbleiterkörpers (2) ein Kontakt (26) vorgesehen ist, der elektrisch mit dem Halbleitersubstrat (16) verbunden ist.

4. Halbleiterbauelement nach Anspruch 3,
**dadurch gekennzeichnet,** daß der Kontakt (26) auf einer hochdotierten Zone (25) sitzt, die den gleichen Leitungstyp wie das Halbleitersubstrat (16) hat.

## Claims

1. Semiconductor component having a first semiconductor body (1) containing a transistor and having a second semiconductor body (2) containing an integrated control circuit, in which component both the semiconductor bodies are mechanically joined together by means of one of their principal faces and are in thermal contact with one another, and which semiconductor component also has housing leads for the control circuit, characterised in that the transistor is a power MOSFET, in that both semiconductor bodies are joined together by means of an insulating layer (3, 4), in that the control circuit contains a temperature sensor (T3) which is electrically connected to a switch (T1, T2, T4) in such a way that, when a set limit temperature which occurs in the power MOSFET is reached, a signal is generated, and in that one of the housing leads is provided as control input (IN) of the control circuit, and a signal on the control input (IN) switches on the power MOSFET via the control circuit.

2. Semiconductor component according to Claim 1, characterised in that a principal face of the semiconductor body (1) of the power MOSFET is mounted on a heat sink (13), and in that the semiconductor body (2) of the control circuit is seated on the other principal face.

3. Semiconductor component according to Claim 1 or 2, characterised in that the control circuit is built up on a heavily doped semiconductor substrate (16) using self-insulating C-MOS technology, and in that there is provided, on the side of its semiconductor body (2) remote from the power MOSFET, a contact (26) which is electrically connected to the semiconductor substrate (16).

4. Semiconductor component according to Claim 3, characterised in that the contact (26) in seated on a heavily doped zone (25) which is of the same conduction type as the semiconductor substrate (16).

## Revendications

1. Composant à semiconducteurs, comportant un premier corps semiconducteur (1) contenant un transistor et un second corps semiconducteur (2) contenant un circuit de commande intégré, du type dans lequel les deux corps semiconducteurs sont reliés mécaniquement par l'une de leurs surfaces principales et sont en contact thermiques entre eux, et comportant, en outre, des bornes de boîtier pour le circuit de commande, caractérisé par le fait que le transistor est un MOSFET de puissance, que les deux corps semiconducteurs sont reliés entre eux par l'intermédiaire d'une couche isolante (3, 4), que le circuit de commande comporte une sonde de température (T3) qui est reliée électriquement de telle façon avec un commutateur (T1, T2, T4) que le commutateur produit un signal lorsqu'apparaît dans le MOSFET une température limite prédéterminée, et que l'une des bornes du boîtier est prévue en tant qu'entrée de commande (IN) du circuit de commande, un signal à l'entrée de commande (IN) branchant le MOSFET de puissance par l'intermédiaire du circuit de commande.

2. Composant à semiconducteurs selon la revendication 1, caractérisé par le fait qu'une surface principale du corps semiconducteur (1) du MOSFET de puissance est fixée sur un radiateur (13) et que le corps semiconducteur (2) du circuit de commande est monté sur l'autre surface principale.

3. Composant à semiconducteurs selon la revendication 1 ou 2, caractérisé par le fait que le circuit de commande est réalisé sur un substrat semiconducteur fortement dopé (16) et selon la technique C-MOS à autoisolation, et que sur le côté de son corps semiconducteur (2), qui est éloigné du MOSFET de puissance, est prévu un contact (26) qui est relié électriquement au substrat semiconducteur (16).

4. Composant à semiconducteurs selon la revendication 3, caractérisé par le fait que le contact (26) est prévu sur une zone fortement dopée (25) qui est du même type de conduction que celui du substrat semiconducteur (16).
